# EUROPEAN PATENT APPLICATION

(11) **EP 1 162 239 A2**
(43) Date of publication of application: **12.12.2001**
(21) Application number: 01304972.1
(22) Date of filing: 07.06.2001
(51) Int. Cl.: C08L 83/04, C08G 77/04, C08K 3/08

(54) **Thermally conductive silicone rubber composition**

(30) Priority: 08.06.2000 JP 2000171477
(71) Applicant: Dow Corning Toray Silicone Co., Ltd., Tokyo (JP)
(72) Inventor: Enami, Hiroji, c/o Dow Corning Toray Silicone Co, Ichihara-shi, Chiba prefecture (JP); Onishi, Masayuki, Ichihara-shi, Chiba Prefecture (JP); Okawa, Tadashiki, Ichihara-shi, Chiba Prefecture (JP); Amako, Masaakiki, Ichihara-shi, Chiba Prefecture (JP)
(74) Representative: Kyle, Diana

(57) **Abstract**

A thermally conductive silicone rubber composition comprising (A) a curable organopolysiloxane, (B) a curing agent, and (C) a thermally conductive filler surface treated with (D) a silalkylene oligosiloxane described by formula 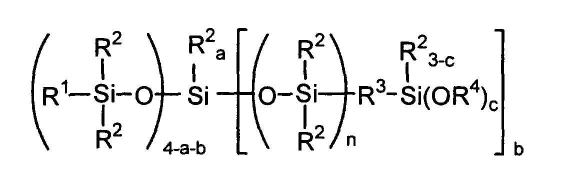 where R¹ is a monovalent hydrocarbon group comprising at least 2 carbon atoms that does not have aliphatic unsaturated bonds, each R² is an independently selected monovalent hydrocarbon group comprising 1 to 10 carbon atoms that does not have aliphatic unsaturated bonds, R³ is an alkylene group comprising at least 2 carbon atoms, R⁴ is an alkyl group, subscript *a* is an integer of 0 to 2 and subscript *b* is an integer of 1 to 3, with the proviso that *a*+*b* is an integer of 1 to 3, subscript *c* is an integer of 1 to 3, and subscript *n* is an integer of 0 or 1. The thermally conductive filler may be treated with component (D) prior to addition to the present composition or may be treated *in situ.*

## Description

The present invention relates to a thermally conductive silicone rubber composition, and more specifically to a thermally conductive silicone rubber composition exhibiting excellent handling properties and moldability even when a large amount of thermally conductive filler is introduced therein in order to form a highly thermally conductive silicone rubber.

In recent years, following an increase in the density and in the degree of integration of hybrid ICs and printed circuit boards, on which transistors, ICs, memory elements, and other electronic components are mounted, various thermally conductive silicone rubbers have been used in order to facilitate the dissipation of heat therefrom.

Japanese Laid-Open Patent Application Publication No. Sho 61(1986)-157569 describes a thermally conductive silicone rubber composition consisting of an organopolysiloxane containing vinyl groups, an organohydrogenpolysiloxane, a thermally conductive filler, an adhesion promoter selected from aminosilane, epoxysilane, and alkyl titanate, and a platinum catalyst.

Japanese Laid-Open Patent Application Publication No. Sho 62(1987)-184058 describes a thermally conductive silicone rubber composition consisting of an organopolysiloxane containing an average of at least two alkenyl groups per molecule, an organopolysiloxane containing an average of three or more silicon-bonded hydrogen atoms per molecule, a thermally conductive filler consisting of zinc oxide and magnesium oxide, a filler treating agent, and a platinum catalyst.

Japanese Laid-Open Patent Application Publication No. Sho 63(1988)-251466 describes a thermally conductive silicone rubber composition consisting of an organopolysiloxane containing at least 0.1 mol% of alkenyl groups per molecule, an organohydrogenpolysiloxane containing at least two silicon-bonded hydrogen atoms per molecule, a spherical alumina powder with an average particle size of from 10 *µ*m to 50 *µ*m, a spherical or non-spherical alumina powder with an average particle size of less than 10 *µ*m, and platinum or a platinum compound.

Japanese Laid-Open Patent Application Publication No. Hei 02(1991)-041362 a thermally conductive silicone rubber composition consisting of an organopolysiloxane containing alkenyl groups, an organohydrogenpolysiloxane, an amorphous alumina powder with an average particle size of from 0.1 *µ*m to 5 *µ*m, a spherical alumina powder with an average particle size of from 5 *µ*m to 50 *µ*m, and a platinum catalyst.

Japanese Laid-Open Patent Application Publication No. Hei 02(1991)-041362 describes a thermally conductive silicone rubber composition consisting of an organopolysiloxane containing at least two silicon-bonded alkenyl groups per molecule, an organohydrogenpolysiloxane containing at least three silicon-bonded hydrogen atoms per molecule, a thermally conductive filler with an average particle size of from 5 *µ*m to 20 *µ*m, an adhesion promoter, and platinum or a platinum compound

In such thermally conductive silicone rubber compositions however the amount of the thermally conductive filler in the thermally conductive silicone rubber composition must be significant in order to form a highly thermally conductive silicone rubber, as a result of which their handling properties and moldability deteriorated.

It is an object of the present invention to provide a thermally conductive silicone rubber composition exhibiting excellent handling properties and moldability even when a large amount of thermally conductive filler is introduced therein in order to form a highly thermally conductive silicone rubber.

A thermally conductive silicone rubber composition comprising (A) a curable organopolysiloxane, (B) a curing agent, and (C) a thermally conductive filler surface treated with (D) a silalkylene oligosiloxane described by formula 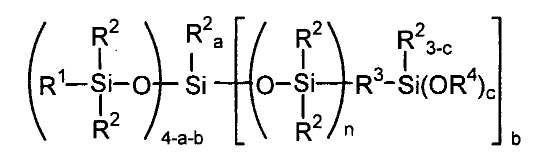 where R¹ is a monovalent hydrocarbon group comprising at least 2 carbon atoms that does not have aliphatic unsaturated bonds, each R² is an independently selected monovalent hydrocarbon group comprising 1 to 10 carbon atoms that does not have aliphatic unsaturated bonds, R³ is an alkylene group comprising at least 2 carbon atoms, R⁴ is an alkyl group, subscript *a* is an integer of 0 to 2 and subscript *b* is an integer of 1 to 3, with the proviso that *a+b* is an integer of 1 to 3, subscript *c* is an integer of 1 to 3, and subscript *n* is an integer of 0 or 1. The thermally conductive filler may be treated with component (D) prior to addition to the present composition or may be treated *in situ.*

A thermally conductive silicone rubber composition comprising (A) a curable organopolysiloxane, (B) a curing agent, and (C) a thermally conductive filler surface treated with (D) a silalkylene oligosiloxane described by formula 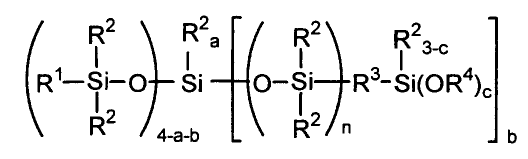 where R' is a monovalent hydrocarbon group comprising at least 2 carbon atoms that does not have aliphatic unsaturated bonds, each R² is an independently selected monovalent hydrocarbon group comprising 1 to 10 carbon atoms that does not have aliphatic unsaturated bonds, R³ is an alkylene group comprising at least 2 carbon atoms, R⁴ is an alkyl group, subscript *a* is an integer of 0 to 2 and subscript *b* is an integer of 1 to 3, with the proviso that *a+b* is an integer of 1 to 3, subscript *c* is an integer of 1 to 3, and subscript *n* is an integer of 0 or 1. The thermally conductive filler may be treated with component (D) prior to addition to the present composition or may be treated *in situ.*

The thermally conductive silicone rubber composition of the present invention is a thermally conductive silicone rubber composition comprising (A) a curable organopolysiloxane, (B) a curing agent, and (C) a thermally conductive filler, in which the surface of component (C) has been treated with (D) a silalkylene oligosiloxane; or a thermally conductive silicone rubber composition comprising component (A), component (B), component (C), and (D).

There are no limitations concerning the cure method of the present composition. The cure method can be, for example, a hydrosilation reaction, a condensation reaction, or a free radical reaction. The preferred cured method is selected from the group consisti of a hydrosilation reaction, a condensation reaction, and a combination of hydrosilation and condensation reaction.

The curable organopolysiloxane of component (A) is the main ingredient of the present composition and if the present composition is hydrosilation reaction curable it is an organopolysiloxane that has an average of not less than 0.1 silicon-bonded alkenyl groups per molecule, preferably an organopolysiloxane that has an average of not less than 0.5 silicon-bonded alkenyl groups per molecule, and especially preferably an organopolysiloxane that has an average of not less than 0.8 silicon-bonded alkenyl groups per molecule. This is due to the fact that when the average number of silicon-bonded alkenyl groups per molecule is below the lower limit of the above-mentioned range, the resultant composition may fail to cure completely. Vinyl, allyl, butenyl, pentenyl, and hexenyl are suggested as the silicon-bonded alkenyl groups in the organopolysiloxane, with vinyl being preferable. In addition, methyl, ethyl, propyl, butyl, pentyl, hexyl, and other alkyl groups; cyclopentyl, cyclohexyl, and other cycloalkyl groups; phenyl, tolyl, xylyl, and other aryl groups; benzyl, phenethyl, and other aralkyl groups; and 3,3,3-trifluoropropyl, 3-chloropropyl, and other halogenated alkyl groups are suggested as examples of groups bonded to silicon atoms besides the alkenyl groups in the organopolysiloxane; preferably, these are alkyl groups and aryl groups, and particularly preferably methyl and phenyl. In addition, there are no limitations concerning the viscosity of the organopolysiloxane, however preferably its viscosity at 25°C is 50 to 100,000 mPa·s, and more preferably 100 to 50,000 mPa·s. This is due to the fact that when the viscosity of component (A) at 25°C is below the lower limit of the above-mentioned range, the physical properties of the resultant silicone rubber tend to markedly deteriorate, and when it exceeds the upper limit of the above-mentioned range the handling properties of the resultant silicone rubber composition tend to markedly deteriorate. There are no limitations concerning the molecular structure of such an organopolysiloxane, and, for example, linear, branched, partially branched linear, or dendritic structures are suggested, with the linear and partially branched linear structures being preferable. In addition, the organopolysiloxane may be a polymer having one of the above molecular structures, a copolymer consisting of such molecular structures, or a mixture of such polymers.

Examples of such organopolysiloxanes include dimethylpolysiloxane having both terminal ends of the molecular chain blocked by dimethylvinylsiloxy groups, dimethylpolysiloxane having both terminal ends of the molecular chain blocked by methylphenylvinylsiloxy groups, copolymer of methylphenylsiloxane and dimethylsiloxane having both terminal ends of the molecular chain blocked by dimethylvinylsiloxy groups, copolymer of methylvinylsiloxane and dimethylsiloxane having both terminal ends of the molecular chain blocked by dimethylvinylsiloxy groups, copolymer of methylvinylsiloxane and dimethylsiloxane having both terminal ends of the molecular chain blocked by trimethylsiloxy groups, methyl(3,3,3-trifluoropropyl)polysiloxane having both terminal ends of the molecular chain blocked by dimethylvinylsiloxy groups, copolymer of methylvinylsiloxane and dimethylsiloxane having both terminal ends of the molecular chain blocked by silanol groups, copolymer of methylphenylsiloxane - methylvinylsiloxane - dimethylsiloxane having both terminal ends of the molecular chain blocked by silanol groups, and copolymer consisting of siloxane units represented by formulas (CH₃)₃SiO_{1/2}, (CH₃)₂(CH₂=CH)SiO_{1/2}, CH₃SiO_{3/2}, and (CH₃)₂SiO_{2/2}.

In addition, if the present composition is a condensation reaction curable composition, the curable organopolysiloxane of component (A) has at least two silanol groups or silicon-bonded hydrolyzable groups per molecule. Methoxy, ethoxy, propoxy, and other alkoxy groups; vinyloxy, and other alkenoxy groups; methoxyethoxy, ethoxyethoxy, methoxypropoxy, and other alkoxyalkoxy groups; acetoxy, octanoyloxy, and other acyloxy groups; dimethylketoxime, methylethylketoxime and other ketoxime groups; isopropenyloxy, 1-ethyl-2-methylvinyloxy, and other alkenyloxy groups; dimethylamino, diethylamino, butylamino, and other amino groups; dimethylaminoxy, diethylaminoxy, and other aminoxy groups; and N-methylacetoamido, N-ethylacetoamido, and other amido groups are suggested as examples of the silicon-bonded hydrolyzable groups of the organopolysiloxane. In addition, methyl, ethyl, propyl, and other alkyl groups; cyclopentyl, cyclohexyl, and other cycloalkyl groups; vinyl, allyl, and other alkenyl groups; phenyl, naphthyl, and other aryl groups; and 2-phenylethyl and other aralkyl groups are suggested as examples of groups bonded to silicon atoms other than the silicon-bonded hydrolyzable groups or silanol groups in the organopolysiloxane.

There are no limitations concerning the viscosity of the organopolysiloxane, however preferably its viscosity at 25°C is within a range of from 20 mPa·s to 100,000 mPa·s, and especially preferably within a range of from 100 mPa·s to 100,000 mPa·s. This is due to the fact that when the viscosity of component (A) at 25°C is below the lower limit of the above-mentioned range, there is a marked deterioration in the physical characteristics of the resultant silicone rubber, and when it exceeds the upper limit of the above-mentioned range the handling properties of the resultant silicone rubber composition tend to deteriorate.

There are no limitations concerning the molecular structure of the organopolysiloxane, and for example suggested are linear, partially branched linear, branched, cyclic, and dendritic structures, with linear structures being preferable. Examples of this type of organopolysiloxane include dimethylpolysiloxane having both terminal ends of the molecular chain blocked by silanol groups, copolymer of methylphenylsiloxane and dimethylsiloxane having both terminal ends of the molecular chain blocked by silanol groups, dimethylpolysiloxane having both terminal ends of the molecular chain blocked by trimethoxysiloxy groups, copolymer of methylphenylsiloxane dimethylsiloxane having both terminal ends of the molecular chain blocked by trimethoxysilyl groups, dimethylpolysiloxane having both terminal ends of the molecular chain blocked by methyldimethoxysiloxy groups, dimethylpolysiloxane having both terminal ends of the molecular chain blocked by triethoxysiloxy groups, and dimethylpolysiloxane having both terminal ends of the molecular chain blocked by trimethoxysilylethyl groups.

When the present composition is a free radical reaction curable composition there are no limitations concerning the curable organopolysiloxane of component (A), but preferably component (A) is an organopolysiloxane having at least one silicon-bonded alkenyl group per molecule. Vinyl, allyl, butenyl, pentenyl, and hexenyl are suggested as examples of the silicon-bonded alkenyl groups of the organopolysiloxane, with vinyl being preferable. In addition, methyl, ethyl, propyl, butyl, pentyl, hexyl, and other alkyl groups; cyclopentyl, cyclohexyl, and other cycloalkyl groups; phenyl, tolyl, xylyl, and other aryl groups; benzyl, phenethyl, and other aralkyl groups; and 3,3,3-trifluoropropyl, 3-chloropropyl, and other halogenated alkyl groups are suggested as groups other than the alkenyl groups that are bonded to silicon atoms in the organopolysiloxane; preferably, these are alkyl and aryl groups, and especially preferably, methyl and phenyl. In addition although there are no limitations concerning the viscosity of the organopolysiloxane, however its viscosity at 25°C is preferably within a range of from 50 mPa·s to 100,000 mPa·s and even more preferably within a range of from 100 mPa·s to 50,000 mPa·s. This is due to the fact that when the viscosity of component (A) at 25°C is below the lower limit of the above-mentioned range there is a marked deterioration in terms of the physical characteristics of the resultant silicone rubber, and when it exceeds the upper limit of the above-mentioned range the handling properties of the resultant silicone rubber composition tend to conspicuously deteriorate.

There are no limitations concerning the molecular structure of the organopolysiloxane, and for example suggested are linear, branched, partially branched linear, and dendritic structures, with linear and partially branched linear structures being preferable. In addition, the organopolysiloxane may be a polymer having one of the above molecular structures, a copolymer consisting of such structures, or a mixture of such polymers. Examples of such organopolysiloxane include dimethylpolysiloxane having both terminal ends of the molecular chain blocked by dimethylvinylsiloxy groups, dimethylpolysiloxane having both terminal ends of the molecular chain blocked by methylphenylvinylsiloxy groups, copolymer of methylphenylsiloxane and dimethylsiloxane having both terminal ends of the molecular chain blocked by dimethylvinylsiloxy groups, copolymer of methylvinylsiloxane and dimethylsiloxane having both terminal ends of the molecular chain blocked by dimethylvinylsiloxy groups, copolymer of methylvinylsiloxane and dimethylsiloxane having both terminal ends of the molecular chain blocked by trimethylsiloxy groups, methyl(3,3,3-trifluoropropyl)polysiloxane having both terminal ends of the molecular chain blocked by dimethylvinylsiloxy groups, copolymer of methylvinylsiloxane and dimethylsiloxane having both terminal ends of the molecular chain blocked by silanol groups, copolymer of methylphenylsiloxane - methylvinylsiloxane - dimethylsiloxane having both terminal ends of the molecular chain blocked by silanol groups, and copolymer consisting of siloxane units represented by formulas (CH₃)₃SiO_{1/2}, (CH₃)₂(CH₂=CH)SiO_{1/2}, CH₃SiO_{3/2}, and (CH₃)₂SiO_{2/2}.

If the present composition is hydrosilation reaction curable, the curing agent of component (B) consists of a platinum catalyst and an organopolysiloxane having an average of no fewer than 2 silicon-bonded hydrogen atoms per molecule. Methyl, ethyl, propyl, butyl, pentyl, hexyl, and other alkyl groups; cyclopentyl, cyclohexyl, and other cycloalkyl groups; phenyl, tolyl, xylyl, and other aryl groups; benzyl, phenethyl, and other aralkyl groups; and 3,3,3-trifluoropropyl, 3-chloropropyl, and other halogenated alkyl groups are suggested as examples of groups bonded to silicon atoms in the organopolysiloxane; preferably these are alkyl and aryl groups and especially preferably methyl and phenyl. In addition although there are no limitations concerning the viscosity of the organopolysiloxane, its viscosity at 25°C is preferably 1 mPa·s to 100,000 mPa·s, and especially preferably 1 mPa·s to 5,000 mPa·s.

There are no limitations concerning the molecular structure of such an organopolysiloxane having silicon bonded hydrogen atoms and for example, linear, branched, partially branched linear, cyclic, or dendritic structures are suggested. The organopolysiloxane may be a polymer having one of the above molecular structures, a copolymer consisting of such molecular structures, or a mixture thereof. Examples of this type or organopolysiloxane having silicon-bonded hydrogen atoms include dimethylpolysiloxane having both terminal ends of the molecular chain blocked by dimethylhydrogensiloxy groups, copolymer of methylhydrogensiloxane and dimethylsiloxane having both terminal ends of the molecular chain blocked by trimethylsiloxy groups, copolymer of methylhydrogensiloxane and dimethylsiloxane having both terminal ends of the molecular chain blocked by dimethylhydrogensiloxy groups, and organosiloxane copolymer consisting of siloxane units represented by the formulas (CH₃)₃SiO_{1/2}, (CH₃)₂HSiO_{1/2}, and SiO_{4/2}.

In the present composition, the content of the organopolysiloxane having silicon-bonded hydrogen atoms is such that the amount of the silicon-bonded hydrogen atoms of is 0.1 to 1.5 mol per 1 mol of the silicon-bonded alkenyl groups of component (A). This is due to the fact that when the content of silicon-bonded hydrogen atoms is below the lower limit of the above-mentioned range, the resultant silicone rubber composition fails to cure completely, and when it exceeds the upper limit of the above-mentioned range the resultant silicone rubber becomes extremely hard and a large number of cracks appears on its surface.

In addition, the platinum catalyst is a catalyst that promotes the cure of the present composition, with chloroplatinic acid, alcohol solutions of chloroplatinic acid, olefin complexes of platinum, alkenylsiloxane complexes of platinum, and carbonyl complexes of platinum suggested as examples thereof.

In the present invention, the content of the platinum catalyst is such that the amount of platinum metal by weight relative to component (A) is 0.01 to 1,000 ppm, and preferably 0.1 to 500 ppm. This is due to the fact that when the content of platinum metal is below the lower limit of the above-mentioned range the resultant silicone rubber composition may fail to completely cure, and even if an amount exceeding the upper limit of the above-mentioned range is added the cure rate of the resultant silicone rubber composition does not improve.

If the present composition is a condensation reaction curable composition, component (B) is characterized by consisting of a silane having at least three silicon-bonded hydrolyzable groups per molecule or a hydrolyzate thereof and if necessary a condensation reaction catalyst. Methoxy, ethoxy, propoxy, and other alkoxy groups; vinyloxy, and other alkenoxy groups; methoxyethoxy, ethoxyethoxy, methoxypropoxy, and other alkoxyalkoxy groups; acetoxy, octanoyloxy, and other acyloxy groups; dimethylketoxime, methylethylketoxime and other ketoxime groups; isopropenyloxy, 1-ethyl-2-methylvinyloxy, and other alkenyloxy groups; dimethylamino, diethylamino, butylamino, and other amino groups; dimethylaminoxy, diethylaminoxy, and other aminoxy groups; and N-methylacetoamido, N-ethylacetoamido, and other amido groups are suggested as examples of the silicon-bonded hydrolyzable groups of the silane. In addition, monovalent hydrocarbon groups may be bonded to the silane, with methyl, ethyl, propyl, butyl, pentyl, hexyl, heptyl, octyl, nonyl, decyl, octadecyl, and other alkyl groups; cyclopentyl, cyclohexyl, and other cycloalkyl groups; vinyl, allyl, and other alkenyl groups; phenyl, tolyl, xylyl, and other aryl groups; benzyl, phenethyl, phenylpropyl, and other aralkyl groups; and 3-chloropropyl, 3,3,3-trifluoropropyl and other halogenated alkyl groups suggested as such monovalent hydrocarbon groups. Methyltriethoxysilane, vinyltriethoxysilane, vinyltriacetoxysilane, and ethyl orthosilicate are suggested as examples of such silanes or partial hydrolyzates thereof.

In the present composition, the content of the silane or partial hydrolyzates thereof is preferably 0.01 to 20 parts by weight and especially preferably 0.1 to 10 parts by weight, per 100 parts by weight of component (A). This is due to the fact that when the content of the silanes or their partial hydrolyzates is below the lower limit of the above-mentioned range, the storage stability of the resultant composition decreases and its adhesive properties tend to deteriorate, and when it exceeds the upper limit of the above-mentioned range the cure rate of the resultant composition tends to become significantly slower.

A condensation reaction catalyst is an optional component, for example, when using a silane having aminoxy, amino, ketoxime, and other groups as a curing agent. Examples of such condensation reaction catalyst include tetrabutyl titanate, tetraisopropyl titanate, and other organic titanic acid esters; diisopropoxybis(acetylacetate)titanium, diisopropoxybis(ethylacetoacetate)titanium, and other organotitanium chelate compounds; aluminum tris(acetylacetonate), aluminum tris(ethylacetoacetate), and other organoaluminum compounds; zirconium tetra(acetylacetonate), zirconium tetrabutylate, and other organozirconium compounds; dibutyltin dioctoate, dibutyltin dilaurate, butyltin-2-ethylhexoate, and other organotin compounds; tin naphthenate, tin oleate, tin butylate, cobalt naphthenate, zinc stearate, and other metal salts of organic carboxylic acids; hexylamine, dodecylamine phosphate, and other amine compounds and their salts; benzyltriethylammonium acetate and other quaternary ammonium salts; potassium acetate, lithium nitrate, and other lower aliphatic acid salts of alkali metals; dimethylhydroxylamine, diethylhydroxylamine, and other dialkylhydroxylamine; and organosilicon compounds containing guanidyl groups.

The content of the condensation reaction catalyst in the present composition is not critical, however preferably it is 0.01 to 20 parts by weight and more preferably 0.1 to 10 parts by weight per 100 parts by weight of component (A). The reason for this is that if the catalyst is a necessary component, the resultant composition may fail to cure completely when the content of the catalyst is below the lower limit of the above-mentioned range and the storage stability of the resultant composition may decrease when it exceeds the upper limit of the above-mentioned range.

When the present composition is a free radical reaction curable composition, component (B) is an organic peroxide. Benzoyl peroxide, dicumyl peroxide, 2,5-dimethylbis(2,5-*t*-butylperoxy)hexane, di-*t*-butyl peroxide, and *t*-butyl perbenzoate are suggested as examples of the organic peroxides. The amount of added organic peroxide is preferably within a range of from 0.1 to 5 parts by weight per 100 parts by weight of the above-described organopolysiloxane of component (A).

The thermally conductive filler of component (C) imparts thermal conductivity to the resultant silicone rubber and is exemplified by aluminum powder, copper powder, nickel powder, and other metal powders; alumina powder, magnesium oxide powder, beryllium oxide powder, chromium oxide powder, titanium oxide powder, and other metal oxide powders; boron nitride powder, aluminum nitride powder, and other metal nitride powders; boron carbide powder, titanium carbide powder, silicon carbide powder, and other metal carbide powders. In particular, when electrical insulating properties are required of the resultant silicone rubber, metal oxide powders, metal nitride powders, or metal carbide powders are preferable, with alumina powder being especially preferable. The above-mentioned powders can be used as the thermally conductive filler of component (C) singly or as a combination of two or more powders. There are no limitations concerning the average particle size of component (C), however preferably it is 0.1 *µ*m to 100 *µ*m. In addition when alumina powder is used as the thermally conductive filler of component (C), preferably a mixture of (C-1) a spherical alumina powder with an average particle size of from 5 *µ* m to 50 *µ*m and (C-2) a spherical or amorphous alumina powder with an average particle size of from 0.1 *µ*m to 5 *µ*m is used, and particularly preferably the mixture is made up of 30 to 90 wt% of component (C-1) and 10 to 60 wt% of component (C-2).

There are no limitations concerning the content of component (C) in the present composition, but in order to form a silicone rubber possessing excellent thermal conductivity preferably it is 500 to 2,500 parts by weight, more preferably 500 to 2,000 parts by weight, and especially preferably 800 to 2,000 parts by weight per 100 parts by weight of component (A). This is due to the fact that when the content of component (C) is above the upper limit of the above-mentioned range, the thermally conductive filler precipitates and undergoes separation if the resultant silicone rubber composition is stored over an extended period of time, and the thermal conductivity of the resultant silicone rubber may be insufficient when it exceeds the lower limit of the above-mentioned range.

The present composition is characterized by a preparation process, in which the surface of the above-mentioned component (C) in a thermally conductive silicone rubber composition consisting of at least the above-mentioned component (A) to component (C) is treated with the silalkylene oligosiloxane of component (D); or the silalkylene oligosiloxane of component (D) is introduced into a thermally conductive silicone rubber composition consisting of at least the above-mentioned component (A) to component (C).

The silalkylene oligosiloxane of component (D) is a characteristic component, which is used to impart excellent handling properties and moldability to the present composition even if a large amount of thermally conductive filler of component (C) is introduced into the present composition in order to form a silicone rubber of high thermal conductivity, and is described by formula 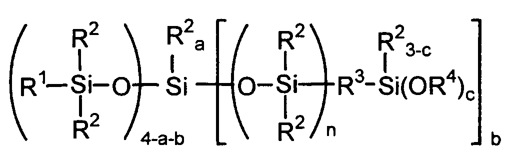 R¹ in the formula above is a monovalent hydrocarbon group comprising at least 2 carbon atoms that does not have aliphatic unsaturated bonds, preferably a monovalent hydrocarbon group comprising 6 to 20 carbon atoms that does not have aliphatic unsaturated bonds. Ethyl, propyl, butyl, pentyl, hexyl, heptyl, octyl, nonyl, decyl, undecyl, dodecyl, tridecyl, tetradecyl, pentadecyl, hexadecyl, heptadecyl, octadecyl, nonadecyl, eicosyl, and other linear alkyl groups; 2-methylundecyl, 1-hexylheptyl, and other branched alkyl groups; cyclododecyl, and other cyclic alkyl groups; 2-(2,4,6-trimethylphenyl)propyl, and other aralkyl groups are suggested as examples of such monovalent hydrocarbon groups of R¹. Preferably R¹ is a linear alkyl group comprising 2 to 20 carbon atoms, and more preferably linear alkyl groups comprising 6 to 20 carbon atoms. Each R² in the formula is an independently selected monovalent hydrocarbon group comprising 1 to 10 carbon atoms that does not have aliphatic unsaturated bonds, for example methyl, ethyl, propyl, butyl, hexyl, decyl, and other linear alkyl groups; isopropyl, *tert*-butyl, isobutyl, and other branched alkyl groups; cyclohexyl and other cyclic alkyl groups; phenyl, tolyl, xylyl, and other aryl groups; benzyl, phenethyl, and other aralkyl groups. Preferably R² is an alkyl group comprising 1 to 4 carbon atoms, and especially preferably methyl and ethyl. R³ in the above formula is an alkyl group comprising at least 2 carbon atoms exemplified by methylmethylene, ethylene, butylene, and hexylene. R³ is preferably ethylene, methylmethylene, and hexylene, and especially preferably ethylene and methylmethylene. R⁴ in the above formula is an alkyl group, for example, methyl, ethyl, propyl, butyl, hexyl, decyl, and other linear alkyl groups; isopropyl, *tert*-butyl, isobutyl, and other branched alkyl groups; and cyclohexyl, and other cyclic alkyl groups. Preferably R⁴ is an alkyl comprising 1 to 4 carbon atoms, and more preferably methyl and ethyl. In addition, in the above formula the subscript *a* is an integer of 0 to 2, the subscript *b* is an integer of 1 to 3, and *a+b* is an integer of 1 to 3. Especially preferably, subscript *a* is 2 and subscript *b* is 1. In addition, the subscript *c* in the formula above is 1 to 3 and the subscript *n* is 0 or 1.

The silalkylene oligosiloxane of component (D) is exemplified by the following compounds:

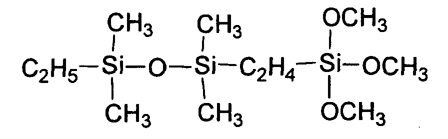

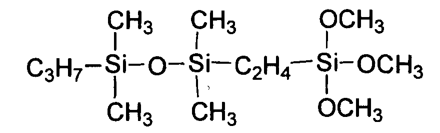

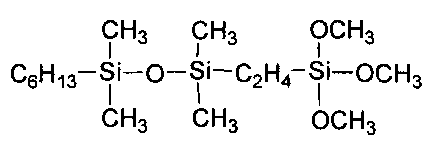

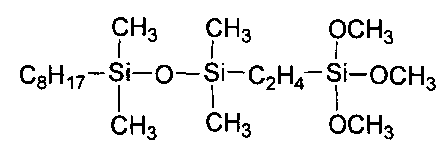

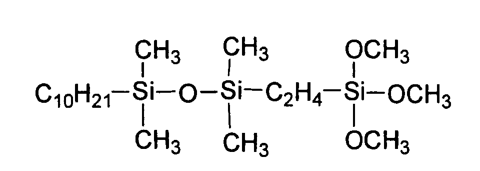

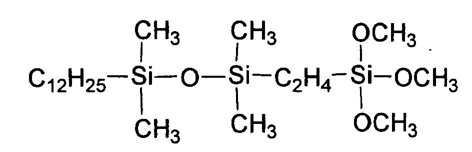

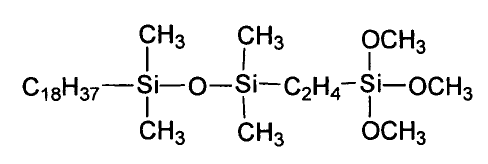

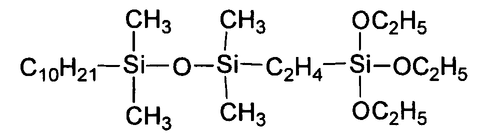

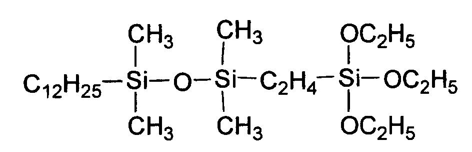

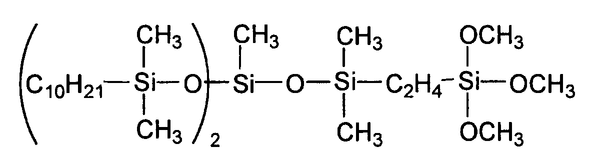

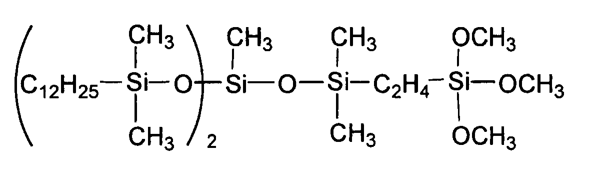

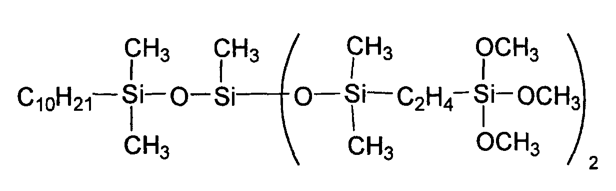

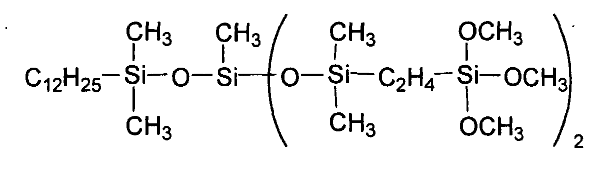

The process used for preparing the silalkylene oligosiloxane of component (D) is exemplified by a process in which a silalkylene oligosiloxane containing silicon-bonded hydrogen atoms described by formula 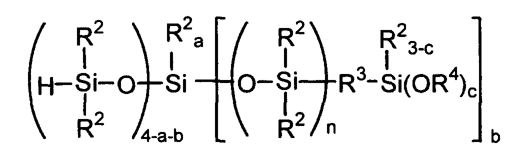 and a hydrocarbon compound having one aliphatic double bond per molecule are subjected to an addition reaction using a hydrosilation reaction catalyst.

In the silalkylene oligosiloxane containing silicon-bonded hydrogen atoms, each R² in the above formula is an independently selected monovalent hydrocarbon group comprising 1 to 10 carbon atoms that does not have aliphatic unsaturated bonds and is exemplified by the same groups as those mentioned above, preferably these are alkyl groups comprising 1 to 4 carbon atoms. Preferably R² in this formula is methyl or ethyl. R³ in the above formula is an alkylene group comprising at least 2 carbon atoms and is exemplified by the same groups as those mentioned above. From the standpoint of the ease of raw material procurement, R³ is preferably ethylene, methylmethylene, and hexylene, with ethylene and methylmethylene being especially preferable. R⁴ in the formula above is an alkyl group exemplified by the same groups as those mentioned above, preferably methyl or ethyl. In the formula above, the subscript *a* is an integer of 0 to 2, the subscript *b* is an integer of 1 to 3, and *a+b* is an integer of 1 to 3. From the standpoint of the ease of raw material procurement, as well as how easy it is to synthesize, it is particularly preferable that subscript *a* be 2 and the subscript *b* be 1. In addition, the subscript *c* in the formula above is an integer of 1 to 3 and the subscript *n* is 0 or 1.

Examples of the silalkylene oligosiloxane containing silicon-bonded hydrogen atoms include trimethoxysilylethyl(dimethylsiloxy)dimethylsilane, triethoxysilylethyl(dimethylsiloxy)dimethylsilane, tripropoxysilylethyl(dimethylsiloxy)dimethylsilane, and other trialkoxysilylethyl(dialkylsiloxy)dialkylsilane compounds; trimethoxysilylethyl {methylbis(dimethylsiloxy)siloxy} dimethylsilane, triethoxysilylethyl {methylbis(dimethylsiloxy)siloxy}dimethylsilane, tripropoxysilylethyl{methylbis(dimethylsiloxy)siloxy}dimethylsilane, and other trialkoxysilylethyl{alkylbis(dialkylsiloxy)siloxy}dialkylsilane compounds; trimethoxysilylethyl {tris(dimethylsiloxy)siloxy}dimethylsilane, triethoxysilylethyl{tris(dimethylsiloxy)siloxy}dimethylsilane, tripropoxysilylethyl{tris(dimethylsiloxy)siloxy}dimethylsilane, and other trialkoxysilylethyl {tris(dialkylsiloxy)siloxy}dimethylsilane compounds; and bis(trimethoxysilylethyldimethylsiloxy)methyl(dimethylsiloxy)silane, bis(triethoxysilylethyldimethylsiloxy)methyl(dimethylsiloxy)silane, bis(tripropoxysilylethyldimethylsiloxy)methyl(dimethylsiloxy)silane, and other bis(trialkoxysilylethyldialkylsiloxy)alkyl(dialkylsiloxy)silane compounds.

In addition, the hydrocarbon compound is characterized by having one aliphatic double bond per molecule and is preferably a hydrocarbon compound comprising 2 to 20 carbon atoms and having one aliphatic double bond per molecule, and especially preferably a hydrocarbon compound comprising 6 to 20 carbon atoms having one aliphatic double bond per molecule. There are no limitations concerning the molecular structure of the hydrocarbon compound, and for example, linear, branched, and cyclic structures are suggested. In addition although there are no limitations concerning the position of the aliphatic double bond of the hydrocarbon compound, however the terminal ends of the molecular chain are preferable because of the better reactivity. Examples of such hydrocarbon compounds include ethylene, propene, 1-butene, 2-butene, 1-pentene, 2-pentene, 1-hexene, 2-hexene, 3-hexene, 1-heptene, 1-octene, 1-nonene, 1-decene, 1-undecene, 1-dodecene, 1-tridecene, 6-tridecene, 1-tetradecene, 1-pentadecene, 1-hexadecene, 1-heptadecene, 1-octadecene, 1-nonadecene, 1-eicocene, and other linear aliphatic hydrocarbon compounds; 2-methylundecene and other branched aliphatic hydrocarbon compounds; cyclododecene and other cyclic aliphatic hydrocarbon compounds; and 2-(2,4,6-trimethylphenyl)propene and other aromatic containing hydrocarbon compounds containing aliphatic double bonds. Preferred are linear aliphatic hydrocarbon compounds.

The hydrosilation reaction catalyst promotes the addition reaction in the above-mentioned preparation process. For example, catalysts based on Group VIII metals are suggested, with platinum catalysts being preferable. The platinum catalysts are exemplified by chloroplatinic acid, alcohol solutions of chloroplatinic acid, olefin complexes of platinum, alkenylsiloxane complexes of platinum, and carbonyl complexes of platinum.

Although in the preparation process there are no limitations concerning the molar ratio of the hydrocarbon compound and silalkylene oligosiloxane, preferably the hydrocarbon compound is reacted in the amount of 0.5 to 1.5 mol, and especially preferably in the amount of 0.95 to 1.1 mol per 1 mol of the silalkylene oligosiloxane.

The process for treating the surface of component (C) with component (D) is exemplified by a process in which after spraying component (C) with component (D) or a solution thereof at room temperature to 200°C while stirring in an agitator, the powder is dried; and a process in which after mixing component (C) with component (D) or a solution thereof in an agitator, the mixture is dried. In addition, the surface of component (C) can be treated with component (D) by a method in which treatment is carried out in-situ (the integral blending method) by adding component (C) and component (D) to component (A). In the integral blending method, there remains a portion of component (D) that does not contribute to the surface treatment of component (C), but if this does not create any particular problems it may be allowed to remain in the thermally conductive silicone rubber composition as is.

When the surface of component (C) is pre-treated with component (D), there are no limitations concerning the amount of component (D) used for treatment, but preferably it is 0.1 to 10 parts by weight, and especially preferably 0.1 to 5 parts by weight per 100 parts by weight of component (C). This is due to the fact that if the composition contains a large amount of component (C), when the content of component (D) is below the lower limit of the above-mentioned range, the handling properties and moldability of the resultant thermally conductive silicone rubber composition may deteriorate and component (C) may easily undergo precipitation and separation in storage, and if it exceeds the upper limit of the above-mentioned range there is no appreciable difference in terms of treatment effects. In addition, when the surface of component (C) is treated in accordance with the integral blending method, or when only component (D) is introduced in the thermally conductive silicone rubber composition, there are no limitations concerning the content of component (D), but preferably it is 0.1 to 10 parts by weight, and especially preferably, 0.1 to 5 parts by weight per 100 parts by weight of component (C). This is due to the fact that when the content of component (D) is below the lower limit of the above-mentioned range and a large amount of component (C) is introduced into the composition, the handling properties and moldability of the resultant thermally conductive silicone rubber composition may deteriorate and component (C) may easily precipitate and separate in storage, and when the upper limit of the above-mentioned range is exceeded the physical properties of the resultant thermally conductive silicone rubber composition may deteriorate.

Furthermore, so long as the object of the present invention is not impaired, fumed silica, precipitated silica, fumed titanium oxide, and other fillers; fillers obtained by treating the surface of the above fillers with organosilicon compounds to render them hydrophobic; acetylene compounds, hydrazine compounds, phosphine compounds, mercaptan compounds, and other addition reaction inhibitors; pigments, dyes, fluorescent dyes, heat resistant additives, flame retardancy-imparting agents except for triazole compounds, plasticizers, and adhesion promoters can be added to the present composition as other optional components.

There are no limitations concerning the method used to cure the present composition, and for example suggested is a method in which after molding the present composition it is allowed to stand at room temperature; and a method in which after molding the present composition is heated to 50 to 200°C. In addition, although there are no limitations concerning the physical properties of the thus obtained silicone rubber, which may be for example extremely hard rubber or rubber of low hardness, in other words, gel-like rubber. From the standpoint of firm adhesion of the resultant silicone rubber to components as a heat dissipating material, as well as excellent handling properties, its Type E durometer hardness according to JIS K 6253 should preferably be within the range of from 5 to 90.

### Application Examples

The thermally conductive silicone rubber composition of the present invention is explained in detail by referring to application examples. The characteristics indicated in the application examples are values obtained at 25°C. In addition, the characteristics of thermally conductive silicone rubber compositions were measured in the following manner.

### Penetration of thermally conductive silicone rubber composition

The 1/4 cone penetration of the composition was measured by placing the thermally conductive silicone rubber composition in a 50-mL glass beaker in accordance with the method specified in JIS K 2220. In addition, it should be noted that a large penetration value points to a considerable plasticity of the silicone rubber composition and means that it has superior handling properties.

### Moldability of thermally conductive silicone rubber composition

A thermally conductive silicone rubber composition curable by a hydrosilation reaction was sandwiched between sheets of 50-*µ*m PET (polyethylene terephthalate) film so as to produce a layer with a thickness of 1 mm and cured by heating at 100°C for 30 min. After that, the PET film sheets were peeled off and visual examination was carried out to determine whether a silicone rubber sheet had been formed. Evaluation was performed designating those cases in which the sheet had been formed without any problems as O: excellent moldability; those cases in which portions of the sheet had come out right and in some places it had undergone cohesive failure as Δ: slightly inferior moldability; and those cases in which a sheet could not be formed due to cohesive failure over a large portion thereof as X: defective moldability.

In addition a condensation reaction curable thermally conductive silicone rubber composition was coated onto a sheet of 50-*µ*m PET film so as to produce a layer with a thickness of 1 mm and allowed to stand for 1 week at room temperature, whereupon the PET film was peeled off and visual examination was carried out to determine whether a silicone rubber sheet had been formed and evaluating in the same manner as above.

### Thermal conductivity of silicone rubber

The thermal conductivity of the silicone rubber was measured in accordance with the hot wire method specified in JIS R 2616 using Quick Thermal Conductivity Meter Model QTM-500 from Kyoto Electronics Manufacturing Co., Ltd.

### Hardness of silicone rubber

The hardness of the silicone rubber was measured as Type E durometer as specified in JIS K 6253.

Reference Example 1. 81.6g (0.61 mol) Of 1,1,3,3-tetramethyldisiloxane were placed in a 300-mL 4-neck flask equipped with a stirrer, a thermometer, a cooling tube, and a dropping funnel under a nitrogen atmosphere. Next, a complex of platinum and 1,3-divinyltetramethyldisiloxane was added such that the amount of platinum metal was 5 ppm based on the total weight of the reaction mixture. The resultant mixture was heated to 60°C and 60g (0.41 mol) of vinyltrimethoxysilane was added thereto in a dropwise manner over 2 hours while subjecting the reaction solution to water cooling and air cooling so as to prevent the temperature of the solution from exceeding 60°C. Upon termination of the dropwise addition, the reaction mixture was agitation for 1 hour at 60°C and analyzed using gas liquid chromatography (GLC), as a result of which it was found that the reaction had terminated because the vinyltrimethoxysilane peak had disappeared. The remaining unreacted 1,1,3,3-tetramethyldisiloxane was stripped off under atmospheric pressure, and 82g (yield: 71.6%) of the 83 to 89°C/15 mmHg fraction was obtained by distillation under reduced pressure. When the fraction was analyzed using nuclear magnetic resonance (NMR) and infrared spectroscopic analysis (IR), the fraction was found to be a silalkylene oligosiloxane described by formula 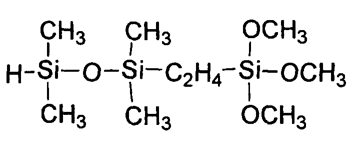 The purity of the siloxane, as determined by GLC, was 100%.

Reference Example 2. 15g (0.053 mol) Of the silalkylene oligosiloxane prepared in Reference Example 1 were placed, under a nitrogen atmosphere, in a 100-mL 4-neck flask equipped with a reflux condenser, a thermometer, and a dropping funnel. Subsequently, a complex of platinum with 1,3-divinyltetramethyldisiloxane was added thereto such that the amount of platinum metal was 0.5 ppm based on the total weight of the reaction mixture. After heating the resultant mixture to 80°C, 7.8g (0.056 mol) of 1-decene were added thereto in a dropwise manner. Upon termination of the dropwise addition, the mixture was agitation for 1.5 hours at 80 to 130°C and the reaction mixture was sampled and analyzed using GLC, as a result of which it was determined that the reaction had terminated because the peak of the silalkylene oligosiloxane prepared in Reference Example 1 had practically disappeared. Low-boiling fractions were stripped off under reduced pressure and heating, obtaining 22.1 g (yield: 98.4%) of liquid. The liquid was analyzed using NMR and IR and found to be a silalkylene oligosiloxane described by formula 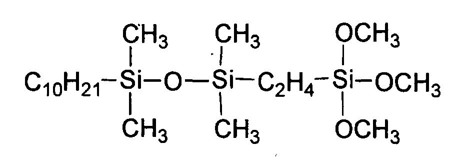 The purity of the siloxane, as determined by GLC, was 96.5%.

Reference Example 3. An addition reaction was carried out in the same manner as in Application Example 2 using 20g (0.071 mol) of the silalkylene oligosiloxane prepared in Reference Example 1, a complex of platinum and 1,3-divinyltetramethyldisiloxane (such that the amount of platinum metal was 0.75 ppm based on the total weight of the reaction mixture), and 6.9g (0.082 mol) of 1-octene. As a result of after-treatment carried out in the same manner as in Reference Example 2, 27.3g (yield: 97.7%) of liquid was obtained. The liquid was analyzed using NMR and IR, and found to be a silalkylene oligosiloxane described by formula: 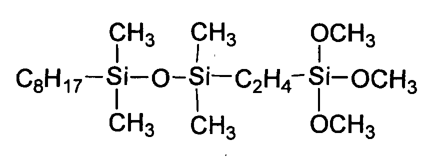 The purity of the siloxane, as determined by GLC, was 100%.

Reference Example 4. An addition reaction was carried out in the same manner as in Application Example 2 using 20g (0.071 mol) of the silalkylene oligosiloxane prepared in Reference Example 1, a complex of platinum and 1,3-divinyltetramethyldisiloxane (such that the amount of platinum metal was 1 ppm based on the total weight of the reaction mixture), and 12.5g (0.075 mol) of 1-dodecene. As a result of after-treatment carried out in the same manner as in Reference Example 2, 27.8g (yield: 87%) of liquid was obtained. The liquid was analyzed using NMR and IR, and the liquid was found to be a silalkylene oligosiloxane described by formula: 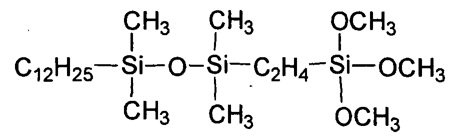 The purity of the siloxane, as determined by GLC, was 100%.

Reference Example 5. A surface treated alumina powder was prepared by placing 450 parts by weight of a spherical alumina powder with an average particle size of 10 *µ*m, 450 parts by weight of an amorphous alumina powder with an average particle size of 2.2 *µ*m, and 5 parts by weight of the silalkylene oligosiloxane prepared in Reference Example 3 described by formula 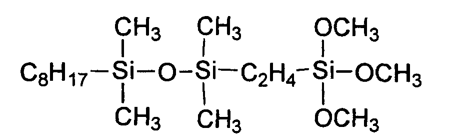 in a blender and mixing them for 2 hours at 160°C in a stream of nitrogen gas.

Reference Example 6. A surface treated aluminum powder was prepared by placing 450 parts by weight of a spherical alumina powder with an average particle size of 10 *µ*m, 450 parts by weight of an amorphous alumina powder with an average particle size of 2.2 *µ*m, and 10 parts by weight of methyltrimethoxysilane in a blender and mixing them for 2 hours at 160°C in a stream of nitrogen gas.

Reference Example 7. A surface treated alumina powder was prepared by placing 450 parts by weight of a spherical alumina powder with an average particle size of 10 *µ*m, 450 parts by weight of an amorphous alumina powder with an average particle size of 2.2 *µ*m, and 5 parts by weight of an oligosiloxane described by formula 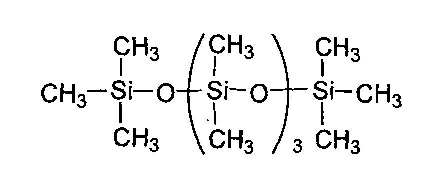 in a blender and mixing them for 2 hours at 160°C in a stream of nitrogen gas.

Application Example 1. An addition reaction curable silicone rubber composition was prepared by uniformly mixing 900 parts by weight of the surface treated aluminum powder prepared in Reference Example 5, 98 parts by weight of dimethylpolysiloxane with a viscosity of 930 mPa·s having an average of one silicon-bonded vinyl group per molecule (vinyl group content = 0.11 wt%) and having the terminal ends of the molecular chain blocked by dimethylvinylsiloxy groups and trimethylsiloxy groups, 0.54 parts by weight of a copolymer of methylhydrogensiloxane and dimethylsiloxane with a viscosity of 4 mPa·s having both terminal ends of the molecular chain blocked by trimethylsiloxy groups (content of silicon-bonded hydrogen atoms = 0.78 wt%), and 0.2 parts by weight of a 1,3-divinyl-1,1,3,3-tetramethyldisiloxane complex of platinum with a platinum content of 0.5 wt%. The characteristics of the silicone rubber composition are shown in Table 1.

Comparative Example 1. With the exception of using the surface treated alumina powder prepared in Reference Example 6 instead of the surface treated alumina powder prepared in Reference Example 5, which was used in Application Example 1, an addition reaction curable silicone rubber composition was prepared in the same manner as in Application Example 1. The characteristics of the silicone rubber composition are shown in Table 1.

Comparative Example 2. With the exception of using the surface treated alumina powder prepared in Reference Example 7 instead of the surface treated alumina powder prepared in Reference Example 5, which was used in Application Example 1, an addition reaction curable silicone rubber composition was prepared in the same manner as in Application Example 1. The characteristics of the silicone rubber composition are shown in Table 1.

Comparative Example 3. An addition reaction curable silicone rubber composition was prepared by uniformly mixing 450 parts by weight of a spherical alumina powder with an average particle size of 10 *µ*m, 450 parts by weight of an amorphous alumina powder with an average particle size of 2.2 *µ*m, 98 parts by weight of dimethylpolysiloxane with a viscosity of 930 mPa·s having an average of 1 silicon-bonded vinyl group per molecule (vinyl group content = 0.11 wt%) and having the terminal ends of the molecular chain blocked by dimethylvinylsiloxy groups and trimethylsiloxy groups, 0.49 parts by weight of a copolymer of methylhydrogensiloxane and dimethylsiloxane with a viscosity of 4 mPa·s having both terminal ends of the molecular chain blocked by trimethylsiloxy groups (content of silicon-bonded hydrogen atoms = 0.78 wt%), and 0.2 parts by weight of a 1,3-divinyl-1,1,3,3-tetramethyldisiloxane complex of platinum with a platinum content of 0.5 wt%. The characteristics of the silicone rubber composition are shown in Table 1.

Application Example 2. A silicone rubber base was prepared by placing 95 parts by weight of dimethylpolysiloxane with a viscosity of 360 mPa·s having both terminal ends of the molecular chain blocked by dimethylvinylsiloxy groups (vinyl group content = 0.48 wt%), 450 parts by weight of a spherical alumina powder with an average particle size of 10 *µ*m, 450 parts by weight of an amorphous alumina powder with an average particle size of 2.2 *µ*m, and 10 parts by weight of the silalkylene oligosiloxane prepared in Reference Example 2 described by formula

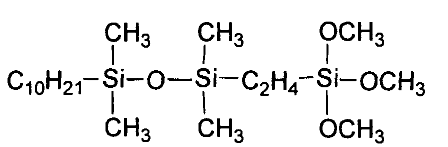

Next, an addition reaction curable silicone rubber composition was prepared by uniformly mixing 0.87 parts by weight of dimethylpolysiloxane with a viscosity of 16 mPa·s having both terminal ends of the molecular chain blocked by dimethylhydrogensiloxy groups (content of silicon-bonded hydrogen atoms = 0.13 wt%), 0.87 parts by weight of a copolymer of methylhydrogensiloxane and dimethylsiloxane with a viscosity of 4 mPa·s having both terminal ends of the molecular chain blocked by trimethylsiloxy groups (content of silicon-bonded hydrogen atoms = 0.78 wt%), and 0.2 parts by weight of a 1,3-divinyl-1,1,3,3-tetramethyldisiloxane complex of platinum with a platinum content of 0.5 wt% with the entire silicone rubber base. The characteristics of the silicone rubber composition are shown in Table 1.

Comparative Example 4. A silicone rubber base was prepared by mixing 90 parts by weight of dimethylpolysiloxane with a viscosity of 360 mPa·s having both terminal ends of the molecular chain blocked by dimethylvinylsiloxy groups (vinyl group content = 0.48 wt%), 450 parts by weight of a spherical alumina powder with an average particle size of 10 *µ*m, 450 parts by weight of an amorphous alumina powder with an average particle diameter of 2.2 *µ*m, and 5 parts by weight of 3-glycidoxypropyltrimethoxysilane.

Next, an addition reaction curable silicone rubber composition was prepared by uniformly mixing 0.87 parts by weight of dimethylpolysiloxane with a viscosity of 16 mPa·s having both terminal ends of the molecular chain blocked by dimethylhydrogensiloxy groups (content of silicon-bonded hydrogen atoms = 0.13 wt%), 0.87 parts by weight of a copolymer of methylhydrogensiloxane and dimethylsiloxane with a viscosity of 4 mPa·s having both terminal ends of the molecular chain blocked by trimethylsiloxy groups (content of silicon-bonded hydrogen atoms = 0.78 wt%), and 0.2 parts by weight of a 1,3-divinyl-1,1,3,3-tetramethyldisiloxane complex of platinum with a platinum content of 0.5 wt% with the entire silicone rubber base. The characteristics of the silicone rubber composition are shown in Table 1.

Application Example 3. A silicone rubber base was prepared by mixing 94 parts by weight of organopolysiloxane consisting of 93.50 mol% of siloxane units represented by the formula: (CH₃)₂SiO_{2/2}, 3.30 mol% of siloxane units represented by the formula CH₃SiO_{3/2}, 2.60 mol% of siloxane units represented by the formula (CH₃)₃SiO_{1/2}, and 0.60 mol% of siloxane units represented by the formula (CH₃)₂(CH₂=CH)SiO_{1/2} (vinyl group content = 0.22 wt%), 450 parts by weight of a spherical alumina powder with an average particle size of 10 *µ*m, 450 parts by weight of an amorphous alumina powder with an average particle diameter of 2.2 *µ*m, and 5 parts by weight of the silalkylene oligosiloxane prepared in Reference Example 4 described by formula

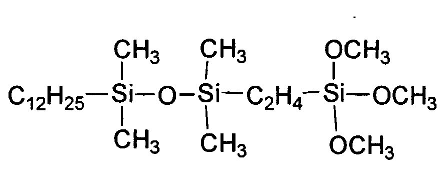

Next, an addition reaction curable silicone rubber composition was prepared by uniformly mixing 6.03 parts by weight of dimethylpolysiloxane with a viscosity of 16 mPa·s having both terminal ends of the molecular chain blocked by dimethylhydrogensiloxy groups (content of silicon-bonded hydrogen atoms = 0.13 wt%) and 0.2 parts by weight of a 1,3-divinyl-1,1,3,3-tetramethyldisiloxane complex of platinum with a platinum content of 0.5 wt% with the entire silicone rubber base. The characteristics of the silicone rubber composition are shown in Table 1.

Application Example 4. A silicone rubber base was prepared by placing 94 parts by weight of dimethylpolysiloxane with a viscosity of 700 mPa·s having both terminal ends of the molecular chain blocked by trimethoxysiloxy groups, 450 parts by weight of a spherical alumina powder with an average particle size of 10 *µ*m, 450 parts by weight of an amorphous alumina powder with an average particle size of 2.2 *µ*m, and 5 parts by weight of the silalkylene oligosiloxane prepared in Reference Example 4 described by formula 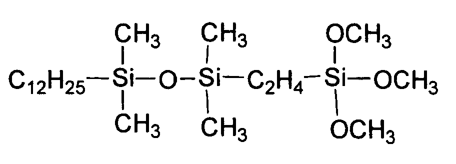 Next, a condensation reaction curable silicone rubber composition was prepared by uniformly mixing 3 parts by weight of methyltrimethoxysilane and 3 parts by weight of tetra(n-butyl) titanate with the entire silicone rubber base. The characteristics of the silicone rubber composition are shown in Table 1.

Comparative Example 5. A silicone rubber base was prepared by forming a mixture comprising 94 parts by weight of dimethylpolysiloxane with a viscosity of 700 mPa·s having both terminal ends of the molecular chain blocked by trimethoxysiloxy groups, 450 parts by weight of a spherical alumina powder with an average particle size of 10 *µ*m, 450 parts by weight of an amorphous alumina powder with an average particle diameter of 2.2 *µ*m, and 3 parts by weight of 3-glycidoxypropyltrimethoxysilane and carrying out preliminary mixing.

Next, a condensation reaction curable silicone rubber composition was prepared by uniformly mixing 3 parts by weight of methyltrimethoxysilane and 3 parts by weight of tetra(n-butyl) titanate with the entire silicone rubber base. The characteristics of the silicone rubber composition are shown in Table 1.

**Table 1**

| Parameter | Appl. Ex. 1 | Appl. Ex. 2 | Appl. Ex. 3 | Appl. Ex. 4 | Comp. Ex. 1 | Comp. Ex. 2 | Comp. Ex. 3 | Comp. Ex.4 | Comp. Ex. 5 |
|---|---|---|---|---|---|---|---|---|---|
| Penetration (mm/10) | 82 | 80 | 95 | 77 | 38 | 22 | 18 | 15 | 30 |
| Moldability | O | O | O | O | X-Δ | X | X | X | X-Δ |
| Thermal Conductivity (W/m·k) | 4.4 | 5.3 | 4.4 | 4.3 | 4.0 | - | - | - | 4.4 |
| Hardness | 43 | 40 | 52 | 45 | 57 | - | - | - | 30 |

## Claims

1. A thermally conductive silicone rubber composition comprising (A) a curable organopolysiloxane, (B) a curing agent, and (C) a thermally conductive filler surface treated with (D) a silalkylene oligosiloxane described by formula (I) 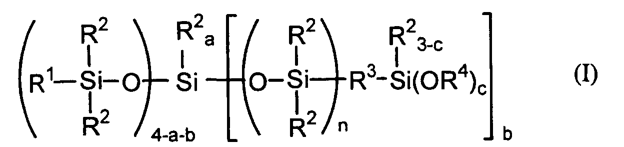 where R¹ is a monovalent hydrocarbon group having at least two carbon atoms that does not have aliphatic unsaturated bonds, each R² is an independently selected monovalent hydrocarbon group comprising 1 to 10 carbon atoms that does not have aliphatic unsaturated bonds, R³ is an alkylene group comprising at least two carbon atoms, R⁴ is an alkyl group, *a* is an integer of 0 to 2 and *b* is an integer of 1 to 3, with the proviso that *a+b* is an integer of 1 to 3, *c* is an integer of 1 to 3, and *n* is an integer of 0 or 1.

2. A thermally conductive silicone rubber composition comprising (A) a curable organopolysiloxane, (B) a curing agent, and (C) a thermally conductive filler, and (D) a silalkylene oligosiloxane described by formula (I) as defined in claim 1.

3. The thermally conductive silicone rubber composition according to claim 1, where the amount of component (D) used for the treatment of component (C) is 0.1 to 10 parts by weight per 100 parts by weight of component (C).

4. The thermally conductive silicone rubber composition according to claim 2 comprising 0.1 to 10 parts by weight component (D) per 100 parts by weight of component (C).

5. The thermally conductive silicone rubber composition according to any of claims 1 to 4, where component (C) is an alumina powder.

6. The thermally conductive silicone rubber composition according to claim 5, where component (C) comprises a mixture of (C-1) a spherical alumina powder with an average particle size of from 5 *µ*m to 50 *µ*m and (C-2) a spherical or amorphous alumina powder with an average particle size of from 0.1 *µ*m to 5 *µ*m.

7. The thermally conductive silicone rubber composition according to claim 6, where component (C) comprises 30 to 90 wt% of component (C-1) and 10 to 60 wt% of component (C-2).

8. The thermally conductive silicone rubber composition according to any of claims 1 to 7, comprising 500 to 2,500 parts by weight component (C) per 100 parts by weight of component (A).

9. The thermally conductive silicone rubber composition according to any of claims 1 to 8, where the thermally conductive silicone rubber composition is cured by a hydrosilation reaction, a condensation reaction or a combination of hydrosilation and condensation reactions.

10. A thermally conductive silicone rubber composition formed from a mixture comprising (A) a curable organopolysiloxane, (B) a curing agent, and (C) a thermally conductive filler, and (D) a silalkylene oligosiloxane described by formula (I) as defined in claim 1.
